**Europäisches Patentamt**

**European Patent Office**

**Office européen des brevets**

(19)

(11) Veröffentlichungsnummer: **0 135 759**
**B1**

(12) ## EUROPÄISCHE PATENTSCHRIFT

(45) Veröffentlichungstag der Patentschrift:
20.07.88

(51) Int. Cl.⁴: **H 03 H 11/24,** H 03 G 3/20

(21) Anmeldenummer: **84109467.5**

(22) Anmeldetag: **09.08.84**

(54) **Schaltungsanordnung zur Umsetzung einer in einem vorgegebenen Arbeitsfrequenzbereich liegenden Eingangsspannung in eine proportionale Ausgangsspannung.**

(30) Priorität: **22.09.83 CH 5152/83**

(43) Veröffentlichungstag der Anmeldung:
**03.04.85 Patentblatt 85/14**

(45) Bekanntmachung des Hinweises auf die Patenterteilung:
**20.07.88 Patentblatt 88/29**

(84) Benannte Vertragsstaaten:
**CH DE FR LI SE**

(56) Entgegenhaltungen:
**DE-A-2 650 583**
**FR-A-2 092 641**
**GB-A-1 277 953**

**PATENTS ABSTRACTS OF JAPAN, Band 2, Nr. 35, 9. März 1978, Seite 11696 E 77**
**PATENTS ABSTRACTS OF JAPAN, Band 6, Nr. 81 (E-107) (959), 19. März 1982**
**ELECTRONIC DESIGN, Band 26, Nr. 15, 19. Juli 1978, Seiten 68-73, ROCHELLE PARK, (US). S. MOORE: "Control analog signals with voltage. FETs, operated as voltage-controlled resistors, can deliver almost any level of performance you may need".**

(73) Patentinhaber: **BBC Brown Boveri AG, Haselstrasse, CH- 5401 Baden (CH)**

(72) Erfinder: **Maschek, Martin, Juchstrasse 10, CH-8116 Würenlos (CH)**
Erfinder: **Mastner, Georg, Dr., Lohnstrasse 5, CH-5443 Niederrohrdorf (CH)**

**0 135 759**

**Beschreibung**

Die Erfindung bezieht sich auf eine Schaltungsanordnung zur Umsetzung einer in einem vorgegebenen Arbeitsfrequenzbereich liegenden Eingangsspannung in eine proportionale Ausgangsspannung mit Hilfe einer Umsetzimpedanz sowie auf eine Verwendung derselben.

Es sind gattungsgemäße Schaltungsanordnungen bekannt mit festen Umsetzimpedanzen, die zur Umsetzung der Eingangsspannung in einen zu derselben entweder proportionalen oder in sonst einem eindeutigen funktionalen Zusammenhang stehenden Strom dienen, welcher gegebenenfalls durch geeignete Mittel, z. B. einen Verstärker mit festem Verstärkungsfaktor, in ein zur Eingangsspannung proportionales Ausgangssignal umgesetzt wird (s. z. B. U. Tietze, Ch. Schenk, Halbleiterschaltungstechnik, 5. Auflage, S. 106-108).

Diese dem Fachmann wohlbekannten Schaltungen sind jedoch nicht oder nur bei Verwendung sehr teurer Komponenten tauglich, wenn Anforderungen zusammentreffen, welche hohe Präzision und Langzeitstabilität in der Umsetzung der Eingangsspannung einschliessen und außerdem eine extreme Dimensionierung der Umsetzimpedanz bedingen.

Derartige Anforderungen treten beispielsweise bei der Verarbeitung des Ausgangssignals eines als kapazitiver Spannungsteiler ausgebildeten Spannungswandlers auf, wo, wegen der normbedingten Beschränkung der Zeitkonstante, die Verwendung eines sehr hochohmigen Umsetzwiderstands als Umsetzimpedanz nötig ist. Wegen des Auftretens transienter Überspannungen muss diese zudem eine hohe Spannungsfestigkeit aufweisen.

Herkömmliche Schaltungen, welche solchen Anforderungen genügen, können zumindest nicht kostengünstig realisiert werden.

Hier will die Erfindung Abhilfe schaffen. Die Erfindung, wie sie in den Ansprüchen gekennzeichnet ist, schafft eine Schaltungsanordung zur Umsetzung einer in einem vorgegebenen Arbeitsfrequenzbereich liegenden Eingangsspannung in eine proportionale Ausgangsspannung, welche äußerst präzis und langzeitstabil arbeitet und sehr kostengünstig hergestellt werden kann.

Die durch die Erfindung erreichten Vorteile sind vor allem darin zu sehen, daß die Anforderungen, die bezüglich Präzision und Stabilität an die Umsetzimpedanz gestellt werden müssen, wesentlich herabgesetzt sind. Dadurch kann sie ungehindert bezüglich anderer technischer Anforderungen, wie z. B. Spannungsfestigkeit, optimiert werden und ist zudem wesentlich kostengünstiger realisierbar.

Insbesondere erfüllen entsprechend angepasste erfindungsgemäße Schaltungsanordnungen alle bei der Verarbeitung des Ausgangssignals eines kapazitiven Spannungswandlers gegebenen Anforderungen.

Im folgenden wird die Erfindung anhand von lediglich Ausführungswege darstellenden Zeichnungen näher erläutert.

Es zeigt:

Fig. 1 eine erste Ausführungsform der Erfindung im Detail und

Fig. 2 eine zweite Ausführungsform der Erfindung in teilweise vereinfachter Darstellung.

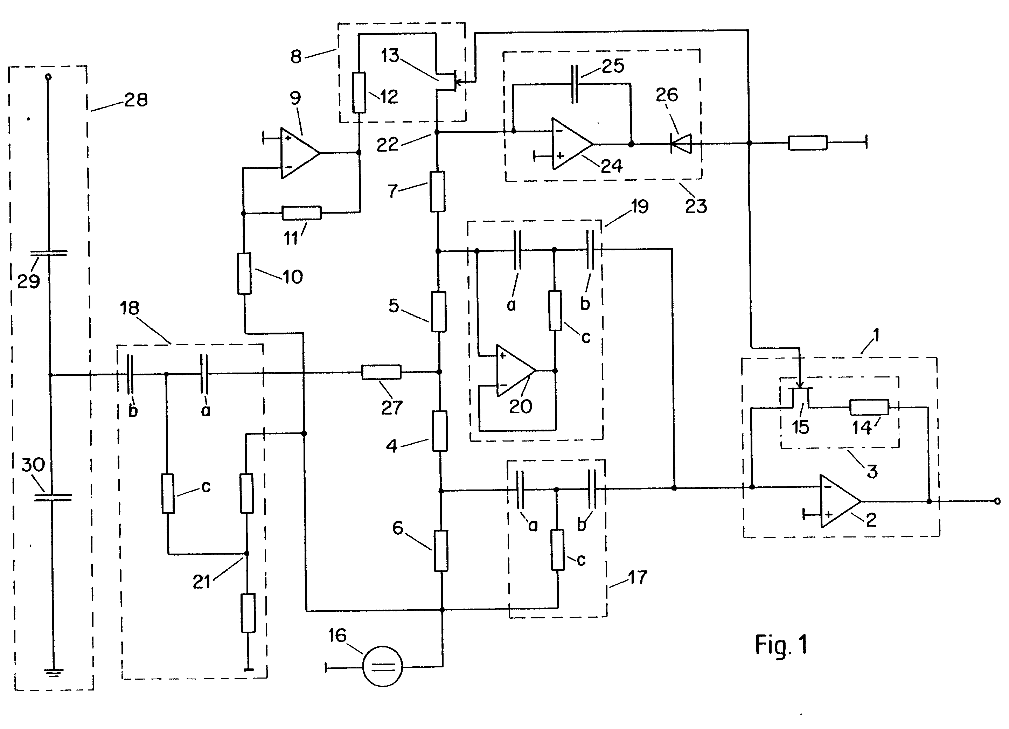

In Fig. 1 ist eine erste Ausführung einer Schaltungsanordnung zur Umsetzung einer in einem vorgegebenen Arbeitsfrequenzbereich oberhalb einer unteren Grenzfrequenz $\omega_0 > 0$ liegenden Eingangswechselspannung $U_e$ in eine proportionale Ausgangsspannung dargestellt, welche in ihrem grundsätzlichen Aufbau einen Umsetzwiderstand mit einem Wert R enthält, welchem ein Verstärker 1 nachgeschaltet ist, der mit einem Operationsverstärker 2 und einem Gegenkopplungswiderstand 3 mit dem Wert $R_3$ aufgebaut ist.

Erfindungsgemäß ist der Umsetzwiderstand im wesentlichen durch Parallelschaltung eines ersten Zweigwiderstandes 4 mit einem Wert $R_4$ und eines zweiten Zweigwiderstands 5 mit einem Wert $R_5 \approx R_4$ gebildet, welche sehr hochohmig sind.

Der erste Zweigwiderstand 4 und der zweite Zweigwiderstand 5 liegen in Serie in einer Brückenschaltung, welche außerdem einen ersten flankierenden Widerstand 6 und einen zweiten flankierenden Widerstand 7 umfasst, welche jeweils einen Wert $R_6 \ll R_4$ haben, einen variablen Abgleichwiderstand 8 sowie einen Operationsverstärker 9 mit einem Vorwiderstand 10 und einem Rückkopplungswiderstand 11. Der Abgleichwiderstand 8 ist durch Serienschaltung eines festen Widerstands 12 und eines Feldeffekttransistors 13 gebildet. Die Werte $R_{10}$ - $R_{12}$ der Widerstände 10 - 12 müssen sehr genau eingehalten werden und dürfen sich auch im Langzeitbetrieb nur innerhalb engster Toleranzen ändern. Es empfiehlt sich, hochwertige Schichtwiderstände zu verwenden, wie sie z. B. von der Firma VISHAY angeboten werden. Gleiches gilt für einen festen Widerstand 14, welcher, in Serie mit einem Feldeffekttransistor 15, den Gegenkopplungswiderstand 3 des Verstärkers 1 bildet. Der Widerstand 14 hat den gleichen Wert $R_{12}$ wie der Widerstand 12. Die Feldeffekttransistoren 13 und 15 sollten möglichst gleiche Kennlinien aufweisen. Derartige abgestimmte Paare von Feldeffekttransistoren sind im Handel erhältlich (z. B. U 421 der Firma Siliconix).

Die Zweigwiderstände 4 und 5, welche Werte im Bereich von einigen 10 MΩ bis einigen 100 MΩ aufweisen können, brauchen keinen sehr hohen Anforderungen bezüglich Präzision und Stabilität zu genügen, daher können hier vergleichsweise preisgünstige Widerstände, z. B. Metallfilmwiderstände, eingesetzt werden. Die Werte der Widerstände 10 - 12 und 14 wiederum können in der Grössenordnung von 1 MΩ und darunter liegen.

Die Brückschaltung wird von einer Spannungsquelle 16 mit einer Gleichspannung beaufschlagt.

Zwischen dem ersten Zweigwiderstand 4 und dem Verstärker 1 liegt eine erste Trennkapazität 17, welche für Gleichstrom undurchlässig und für Wechselstrom oberhalb der unteren Grenzfrequenz $\omega_0$ hinreichend durchlässig ist. In ähnlicher Weise sind in den Eingang eine zweite Trennkapazität 18 und zwischen die zweite Zweigimpedanz 5 und den Verstärker 1 eine dritte Trennkapazität 19 gelegt. Die Trennkapazitäten 17 - 19 sind

2

jeweils als Serienschaltungen einer innenliegenden Teilkapazität a und einer eingangs bzw. ausgangsseitigen Teilkapazität b realisiert, wobei jeweils die innenliegende Teilkapazität a derart überbrückt ist, daß mindestens die Gleichspannungskomponente zu beiden Seiten derselben annähernd gleich gross ist (boot-strapping). Auf diese Weise werden Leckströme über die innenliegende Teilkapazität a fast vollständig verhindert. Die Überbrückung kann z. B. durch einen als Spannungsfolger geschalteten Operationsverstärker 20 oder, falls die Grösse der Gleichspannungskomponente am inneren Anschluß der inneren Teilkapazität a bekannt ist, durch einen von der Spannungsquelle 16 gespeisten Spannungsteiler 21 geschehen. Bei der ersten Trennkapazität 17 ist wegen der relativen Kleinheit des Wertes $R_6$ des ersten flankierenden Widerstands 6 ein direkter Anschluß an die Spannungsquelle 16 möglich. Ein hochohmiger Widerstand c verhindert jeweils, daß in störendem Ausmaß Wechselstrom abfliesst.

An einer Abgleichstelle 22 der Brückenschaltung liegt der Eingang eines als Integrator 23 ausgebildeten Abgleichregelkreises, der mit einem Operationsverstärker 24, welcher über einen Kondensator 25 rückgekoppelt ist, aufgebaut ist sowie einer nachgeschalteten Diode 26. Der Kondensator ist so dimensioniert, daß oberhalb der unteren Grenzfrequenz $\omega_0$ liegende Frequenzen durch den Integrator 23 weitgehend unterdrückt werden. Das Ausgangssignal des Integrators 23 steuert parallel den Feldeffekttransistor 13 im Abgleichwiderstand 8 und den Feldeffekttransistor im Gegenkopplungswiderstand 3 des Verstärkers 1.

Im Eingang der Schaltungsanordnung liegt, der Kapazität 18 nachgeschaltet, ein Kompensationswiderstand 27, welcher etwa den gleichen Wert wie die Parallelschaltung der flankierenden Widerstände 6, 7, also ca. $\frac{R_6}{2}$, aufweist und auf gleiche Weise wie diese realisiert ist.

Die Schaltungsanordnung wird zur Verarbeitung des Ausgangssignals eines Spannungswandlers 28, der als kapazitiver Spannungsteiler mit einer Oberspannungskapazität 29 und einer Unterspannungskapazität 30 ausgebildet ist, verwendet.

Bei einer derartigen Verwendung bedingen die geringen Werte $C_{29}$, $C_{30}$ der Oberspannungskapazität 29 und der Unterspannungskapazität 30, die auf wirtschaftlich vertretbare Weise erreicht werden können - sie liegen im Bereich von einigen pF bzw. einigen nF - und die Beschränkung der Zeitkonstante $\tau$ auf - je nach der Klasse des Wandlers - einige 100 msec bis einige Sekunden, hohe Werte R des Umsetzwiderstandes, da $\tau = R(C_{29} + C_{30})$ gilt und Kompensation von grösseren Phasenfehlern aus Stabilitätsrücksichten vermieden werden soll. Daraus ergeben sich entsprechend hohe, im weiter oben erwähnten Bereich liegende Werte für die Zweigwiderstände 4 und 5.

Die Funktion der Schaltungsanordnung ist nun die folgende:

Die vom Spannungswandler 28 gelieferte Eingangswechselspannung $U_e$ liegt, durch die Trennkapazität 18 übertragen, an dem durch den Kompensationswiderstand 27 und die Parallelschaltung der Zweigimpedanzen 4, 5 gebildeten Umsetzwiderstand mit dem Wert $R = \frac{R_6}{2} + \frac{R_4 R_5}{R_4 + R_5}$ und erzeugt einen Wechselstrom, welcher über die Trennkapazitäten 17 und 19 - sie wirken zusammen mit den flankierenden Widerständen 6 bzw. 7 als Hochpassfilter mit unterhalb $\omega_0$ liegender Grenzfrequenz - an den Eingang des Verstärkers 1 gelangt. Der Operationsverstärker 2 kompensiert den Wechselstrom über den Gegenkopplungswiderstand 3, indem er eine Ausgangsspannung $U_a$ erzeugt, welche den Wert $U_a = -\frac{R_3}{R}U_e$ hat. Der Absolutwert des Verstärkungsfaktors

$$k = \frac{U_a}{U_e} = -\frac{R_3}{R} \tag{1}$$

ist dabei, da $R_3$ wesentlich kleiner als R ist, wesentlich kleiner als eins. Die Brückenschaltung, in welcher die Zweigimpedanzen 4 und 5 in Serie in einem Zweig liegen, wird durch den Integrator 23 ständig in abgeglichenem Zustand gehalten. Sobald sich das Gleichgewicht der Brückenschaltung, etwa durch Änderung eines der Zweigwiderstände, verschiebt, fliesst ein Strom in den Integrator 23, dessen Ausgangsspannung auf das Gate des Feldeffekttransistors 15 wirkt und damit den Drain-Source-Widerstand desselben derart beeinflusst, daß die Brückenschaltung durch Anpassung des Wertes $R_8$ des Abgleichwiderstandes 8 wieder den abgeglichenen Zustand annimmt. Die Bedingung für vollständigen Abgleich ist dabei

$$R_4 + R_5 + 2 R_6 = \frac{R_{11}}{R_{10}} \cdot R_8 \text{, d.h.}$$

$$R_8 = 2 \frac{R_{10}}{R_{11}} \left( \frac{R_4 + R_5}{2} + R_6 \right). \tag{2}$$

Falls sich nun, etwa durch Alterung oder Änderung von Umgebungsparametern der Wert des ersten Zweigwiderstands 4 von $R_4$ zu $R_4(1 + d_4)$, der des zweiten Zweigwiderstands 5 von $R_4$ zu $R_4(1 + d_5)$ und der Wert des Kompensationswiderstands 27 von $\frac{R_6}{2}$ zu $\frac{R_6}{2}(1 + d_{27})$ verändert, so ändert der Umsetzwiderstand seinen Wert von $R = \frac{R_4}{2} + \frac{R_6}{2}$ zu

$$R' = \frac{R_4 \, (1 + d_4) \, (1 + d_5)}{2 \, (1 + \frac{d_4}{2} + \frac{d_5}{2})} + \frac{R_6}{2} \, (1 + d_{27}) \, , \qquad (3)$$

was, unter Vernachlässigung von Termen von quadratischer und höherer Ordnung in den relativen Änderungen der Widerstände, auf

$$R' = \frac{R_4}{2} \, (1 + \frac{d_4}{2} + \frac{d_5}{2}) + \frac{R_6}{2} \, (1 + d_{27}) \qquad (4)$$

$$= R \, (1 + \frac{d_4}{2} + \frac{d_5}{2}) \, (1 + \frac{R_6}{R_4 + R_6} \, \frac{1 + d_{27}}{1 + \frac{d_4}{2} + \frac{d_5}{2}})$$

führt.

Aus der Abgleichbedingung (2) ergibt sich, wenn man annimmt, daß die Werte der flankierenden Widerstände 6 und 7 jeweils einer relativen Änderung $d_6$ unterliegen, daß sich

$$R_8 \text{ von } 2 \, \frac{R_{10}}{R_{11}}(R_4 + R_6) \text{ zu}$$

$$R_8' = 2 \, \frac{R_{10}}{R_{11}} \, [R_4 \, (1 + \frac{d_4}{2} + \frac{d_5}{2}) + R_6 \, (1 + d_6)]$$

$$= R_8 \, (1 + \frac{d_4}{2} + \frac{d_5}{2}) \, (1 + \frac{R_6}{R_4 + R_6} \, \frac{1 + d_6}{1 + \frac{d_4}{2} + \frac{d_5}{2}}) \qquad (5)$$

verändert.

Aus der Annahme, daß der Wert des Kompensationswiderstands 27, der ja gleichartig wie die flankierenden Widerstände 6 und 7 aufgebaut ist, der gleichen relativen Änderung unterliegt wie diese, d.h. $d_{27} = d_6$ ist, ergibt sich aus (4), (5), daß $R_8$ sich Proportional zu R ändert.

Da nun der Gegenkopplungswiderstrand 3 gleich aufgebaut ist wie der Abgleichwiderstand 8 und auch vom Integrator 23 genau gleich gesteuert wird, ändert sich auch der Wert $R_3$ des Gegenkopplungswiderstands 3 Proportional zum Wert des Umsetzwiderstands R und somit bleibt gemäß (1) der Verstärkungsfaktor k gleich.

Der Kompensationswiderstand 27, welcher ausschließlich dazu dient, sozusagen irrtümliche, auf Änderungen in den Werten der den Verstärkungsfaktor k nicht beeinflussenden flankierenden Widerstände 6, 7 zurückgehende Änderungen des Abgleichwiderstands 8 und damit des Gegenkopplungswiderstands 3 zu kompensieren, kann unter Umständen entfallen, da der Einfluß eventueller Änderungen in den Werten der flankierenden Widerstände 6, 7 auf den Abgleichwiderstand 8 wegen $R_6 \ll R_4$ gering ist, wie man aus (5) ersieht.

Die weiter oben beschriebenen, verhältnismässig aufwendigen Ausführungen der Trennkapazitäten 17 - 19 wurden gewählt, um störende Einflüsse von Leckströmen auf die Brückenschaltung auf ein unschädliches Mass zu reduzieren.

Die Werte $C_{17}$ - $C_{19}$ der Trennkapazitäten 17 - 19 sollten wesentlich größer sein als die Werte $C_{29}$ und $C_{30}$ der Kapazitäten des Spannungswandlers 28, damit eine störende Verkleinerung der Zeitkonstante $\tau$ vermieden wird.

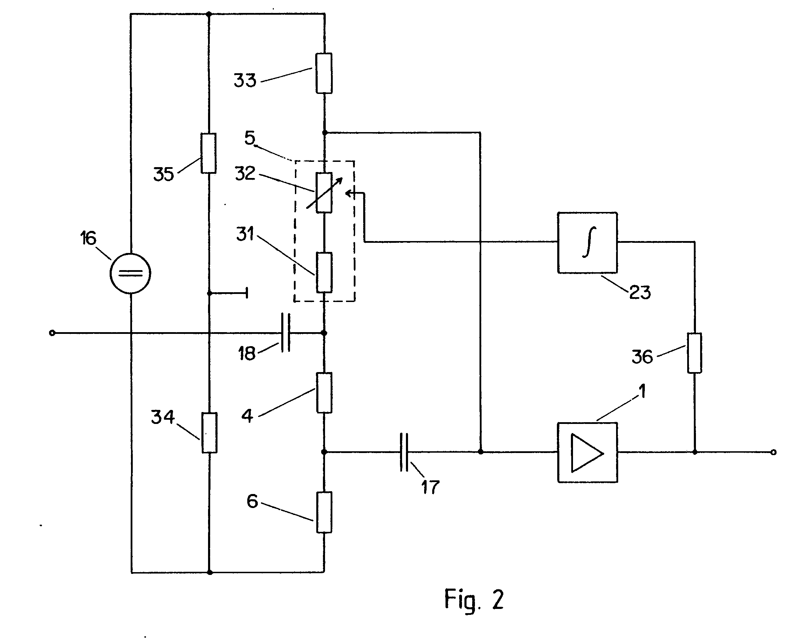

In Fig. 2 ist eine zweite Ausführung einer Schaltungsanordnung zur Umsetzung einer in einem vorgegebenen Arbeitsbereich liegenden Eingangsspannung $U_e$ in eine proportionale Ausgangsspannung dargestellt, welche ebenfalls in ihrem grundsätzlichen Aufbau einen Umsetzwiderstand mit einem Wert R enthält, welchem ein Verstärker 1 nachgeschaltet ist.

Erfindungsgemäß ist der Umsetzwiderstand wiederum durch Parallelschaltung eines ersten Zweigwiderstands 4 mit einem Wert $R_4$ und eines zweiten Zweigwiderstandes 5 mit einem Wert $R_5 \approx R_4$ gebildet. Der zweite Zweigwiderstand 5 ist als Serienschaltung eines festen Widerstands 31 und eines variablen Widerstands 32 realisiert und bildet zugleich den Abgleichwiderstand in einer Brückenschaltung, in der die Zweigwiderstände 4, 5 zusammen mit einem flankierenden Widerstand 6 mit einem Wert $R_6 \ll R_4$ in einem Zweig liegen und welche in ihren übrigen Zweigen Widerstände 33 - 35 enthält, welche vorzugsweise als hochwertige Schichtwiderstände ausgebildet sind. Die Brückenschaltung wird von einer Spannungsquelle 16 mit einer Gleichspannung beaufschlagt.

Der dem eingangsseitigen gegenüberliegende Anschluß der zweiten Zweigimpedanz 5, welcher an einer Abgleichstelle 22 der Brückenschaltung liegt, ist unmittelbar mit dem Eingang des Verstärkers 1 verbunden. Zwischen dem ersten Zweigwiderstand 4 und dem Eingang des Verstärkers 1 liegt eine hochisolierende erste Trennkapazität 17.

Dem Eingang der Schaltungsanordnung ist eine ebenfalls hochisolierende zweite Trennkapazität 18 nachgeschaltet.

Mit dem Ausgang des Verstärkers 1 ist über einen hochohmigen Widerstand 36 der Eingang eines Integrators 23 verbunden, welcher Frequenzen im Arbeitsfrequenzbereich unterdrückt. Er regelt den variablen Widerstand 32.

Der Verstärker 1 kann ähnlich aufgebaut sein wie in der ersten Ausführungsform, allerdings mit einem konstanten Gegenkopplungswiderstand. Der Quotient zwischen seinem Eingangsstrom $I_e$ und der Ausgangsspannung $U_a$, sein Verstärkungsfaktor

$$k' = \frac{U_a}{I_e} \tag{6}$$

darf nur innerhalb engster Grenzen schwanken, was durch Verwendung eines hochwertigen Schichtwiderstands als Gegenkopplungswiderstand erreichbar ist.

Die Trennkapazitäten 17, 18 und der Integrator 23 können ähnlich wie in der ersten Ausführungsform, der variable Widerstand 32 wiederum als Feldeffekttransistor realisiert sein.

Die Schaltungsanordnung funktioniert folgendermassen:

Die Eingangswechselspannung $U_e$ erzeugt an der durch Parallelschaltung der Zweigimpedanzen 4, 5 gebildeten Umsetzimpedanz mit dem Wert $R = \frac{R_4 R_5}{R_4 + R_5}$ einen Wechselstrom

$$I_e = \frac{U_e}{R}, \tag{7}$$

welcher dem Verstärker 1 als Eingangsstrom zufliesst. Der Verstärkungsfaktor $k = \frac{U_a}{U_e}$ der gesamten Schaltungsanordnung ist daher

$$k = \frac{k'}{R} \tag{8}$$

wegen (6), (7).

Die Brückenschaltung wird durch den Integrator 23 ständig im abgeglichenen Zustand gehalten, da jede Abweichung davon einen Gleichstrom am Eingang des Verstärkers 1 hervorruft, welcher dementsprechend an seinem Ausgang eine Gleichspannung erzeugt, die vom Integrator 23 integriert wird. Das Ausgangssignal des Integrators 23 bewirkt daraufhin eine kompensierende Änderung im Wert $R_{32}$ des variablen Widerstands 32 und damit des zweiten Zweigwiderstands 5.

Die Abgleichbedingung der Brückenschaltung ist, sieht man vom flankierenden Widerstand 6 ab,

$$\frac{R_4 + R_5}{R_{33}} = \frac{R_{34}}{R_{35}}, \text{ d.h.}$$

$$R_5 = \frac{R_{33} \cdot R_{34}}{R_{35}} - R_4. \tag{9}$$

Ändert sich der Wert $R_{31}$ des festen Widerstands 31, so wird diese Änderung durch eine entgegengesetzte Änderung von $R_{32}$ vollständig kompensiert. Der Wert $R_5$ des ersten Zweigwiderstands 5 und der Wert R des Umsetzwiderstands ändern sich nicht.

Verändert sich der Wert $R_4$ des ersten Zweigwiderstands 4 zu

$$R_4' = R_4 (1 + d_4), \tag{10}$$

so geht wegen (9) $R_5$ in

$$R_5' = R_5 - R_4 d_4 \approx R_5 (1 - d_4) \tag{11}$$

über.

Der Wert R' des Umsetzwiderstands ergibt sich dann zu

$$R' = \frac{R_4' R_5'}{R_4' + R_5'} = \frac{R_4 R_5 (1 + d_4)(1 - d_4)}{R_4 + R_5 + (R_4 - R_5) d_4} = \frac{R_4 R_5}{R_4 + R_5} = R, \tag{12}$$

falls man $R_5 \approx R_4$ berücksichtigt und einen Term quadratischer Ordnung in $d_4$ vernachlässigt.

Aus (8), (12) und der vorangegangenen Bemerkung folgt nun, daß sich der Verstärkungsfaktor k der Schaltungsanordnung bei Änderung des festen Widerstands 31 oder des ersten Zweigwiderstands 4 nicht ändert.

Bei beiden Ausführungsformen werden die hochwertigen Schichtwiderstände der Eingangsspannung nicht ausgesetzt. Sie können daher auch beim Auftreten transienter Überspannungen weder beschädigt noch durch stärkere Erwärmung in ihren Eigenschaften vorübergehend verändert werden.

Zur weiteren Erhöhung der Sicherheit kann jeweils ein Fensterkomparator vorgesehen werden, welcher das Ausgangssignal des Integrators 23 überwacht und ein Fehlersignal setzt, falls dasselbe wegen eines Defekts in der Schaltungsanordnung einen vorgegebenen Bereich überschreitet.

**Patentansprüche**

1. Schaltungsanordnung zur Umsetzung einer in einem vorgegebenen Arbeitsfrequenzbereich liegenden Eingangsspannung in eine proportionale Ausgangsspannung mit den folgenden Merkmalen:
- Sie enthält eine Verstärkerschaltung mit einem Operationsverstärker (2), der einen Ausgang aufweist, der mit dem Ausgang der Schaltungsanordnung verbunden ist, und der über einen Gegenkopplungswiderstand (3) auf seinen invertierenden Eingang verbunden ist und bei der als Eingangswiderstand eine Umsetzimpedanz (4, 5) zwischen dem genannten Eingang und dem Eingang der Schaltungsanordnung vorgesehen ist;
- die Umsetzimpedanz besteht aus zwei in zwei zueinander parallelen Zweigen angeordneten Widerstanden (4, 5):
- mindestens in einem der beiden Zweige ist mit dem jeweiligen Zweigwiderstand (4 bzw. 5) in Serie eine erste Kapazität (17 bzw. 18) derart angeordnet, daß die beiden Zweigwiderstände (4, 5) für Signale im Arbeitsfrequenzbereich parallel geschaltet sind;
- die beiden Zweigwiderstände (4, 5) sind andererseits in Serie in einen Zweig einer mit einer Gleichspannungsquelle (16) versorgten Brückenschaltung geschaltet;
- es sind Mittel (23, 15, 13 bzw. 32) vorgesehen, durch welche in Abhängigkeit vom Abgleichzustand der Brückenschaltung der Umsetzungsfaktor der Schaltungsanordnung stets so korrigiert wird, daß er trotz einer Veränderung des Widerstandswertes der Zweigwiderstände (4, 5) beispielsweise auf Grund von Alterungserscheinungen oder Temperatureinflüssen, konstant bleiben.

2. Schaltungsanordnung nach Anspruch 1, dadurch gekennzeichnet, daß die beiden Zweigwiderstände (4, 5) wenigstens annähernd gleich sind.

3. Schaltungsanordnung nach Anspruch 1 oder 2, dadurch gekenneichnet, daß zwischen ihrem Eingang und die Umsetzimpedanz (4, 5) eine zweite Kapazität (18) geschaltet ist.

4. Schaltungsanordnung nach einem der Ansprüche 1 bis 3, dadurch gekennzeichnet, daß sie einen in der Brückenschaltung liegenden Abgleichwiderstand (8) enthält, sowie einen Abgleichregelkreis (Integrator 23), dessen Eingang an einer Abgleichstelle (22) der Brückenschaltung liegt und welcher dieselbe durch Einstellung des Abgleichwiderstandes abgleicht.

5. Schaltungsanordnung nach einem der Ansprüche 1 bis 4, dadurch gekennzeichnet, daß in jedem der beiden Zweige mit dem jeweiligen Zweigwiderstand (4, 5) in Serie eine Kapazität (17, 18) derart angeordnet ist, daß die beiden Zweigwiderstände (4, 5) für Signale im Arbeitsfrequenzbereich parallel geschaltet sind.

6. Schaltungsanordnung nach einem der Ansprüche 1 bis 5, dadurch gekennzeichnet, daß der Gegenkopplungswiderstand (3) des Operationsverstärkers (2) variabel ist.

7. Schaltungsanordnung nach einem der Ansprüche 4 bis 6, dadurch gekennzeichnet, daß der Abgleichwiderstand (8) und der Gegenkopplungswiderstand (3) gleich groß, gleichartig ausgebildet und auf gleiche Weise mit dem Abgleichregelkreis (Integrator 23) verbunden sind.

8. Schaltungsanordnung nach einem der Ansprüche 1 bis 7, dadurch gekennzeichnet das mindestens eine Kapazität (17, 18, 19) als Serienschaltung von zwei Teilkapazitäten (a, b) ausgebildet ist und daß die Teilkapazität (a), die näher an der Brückenschaltung angeordnet bzw. mit dieser verbunden ist, durch eine Ausgleichsschaltung (c) derart überbrückt ist, daß die Gleichspannung auf beiden Seiten dieser Teilkapazität (a) annähernd gleich groß ist.

9. Schaltungsanordnung nach einem der Ansprüche 4 bis 9, dadurch gekennzeichnet, daß der Abgleichregelkreis als Integrator (23) ausgebildet ist.

10. Schaltungsanordnung nach einem der Ansprüche 1 bis 9, dadurch gekennzeichnet, daß die Serienschaltung des ersten Zweigwiderstandes (4) und des zweiten Zweigwiderstandes (5) einerseits und der Abgleichwiderstand (8) andererseits in verschiedenen Zweigen der Brückenschaltung liegen.

11. Schaltungsanordnung nach Anspruch 4, dadurch gekennzeichnet, daß einer der Zweigwiderstände (31, 32) den Abgleichwiderstand bildet.

12. Schaltungsanordnung nach einem der Ansprüche 4 oder 11, dadurch gekennzeichnet, daß die Abgleichstelle der Brückenschaltung zwischen einem der Zweigwiderstände (5) und dem Eingang des Operationsverstärkers (1) liegt, und daß der Ableichregelkreis (Integrator 23) durch das Ausgangssignal des Operationsverstärkers (1) gesteuert ist.

13. Verwendung einer Schaltungsanordnung nach einem der Ansprüche 8 bis 12 zur Verarbeitung des Ausgangssignals eines als kapazitiver Spannungsteiler ausgebildeten Spannungswandlers (28).

**Claims**

1. Circuit arrangement for converting an input voltage located within a predetermined operating frequency range into a proportional output voltage having the following features:
   - it contains an amplifier circuit with an operational amplifier (2) which exhibits an output which is connected to the output of the circuit arrangement and which is connected via a feedback resistance (3) to its inverting input and in which a conversion impedance (4, 5) between the said input and the input of the circuit arrangement is provided as input resistance;
   - the conversion impedance consists of two resistances (4, 5) arranged in two mutually parallel branches;
   - a first capacitance (17 and 18, respectively) is arranged in series with the respective branchresistance (4 and 5 respectively) in at least one of the two branches, in such a manner that the two branch resi stances (4, 5) are connected in parallel for signals within the operating frequency range;
   - the two branch resistances (4, 5), on the other hand, are connected in series into one branch of a bridge circuit supplied by a direct-voltage source (16);
   - means (23, 15, 13 and 32, respectively) are provided by means of which the conversion factor of the circuit arrangement is always corrected, in dependence on the state of calibration of the bridge circuit, in such a manner, that it remains constant in spite of a change of the resistance value of the branch resistances (4, 5), for example due to ageing phenomena or temperature influences.

2. Circuit arrangement according to Claim 1, characterized in that the two branch resistances (4, 5) are at least approximately equal.

3. Circuit arrangement according to Claim 1 or 2, characterized in that a second capacitance (18) is connected between its input and the conversion impedance (4, 5).

4. Circuit arrangement according to one of Claims 1 to 3, characterized in that it contains a calibration resistance (8) located in the bridge circuit, and a calibration control loop (integrator 23) the input of which is located at a calibration point (22) of the bridge circuit and which calibrates the latter by setting the calibration resistance.

5. Circuit arrangement according to one of Claims 1 to 4, characterized in that a capacitance (17, 18) is arranged in series with the respective branch resistance (4, 5) in each of the two branches, in such a manner that the two branch resistances (4, 5) are connected in parallel for signals within the operating frequency range.

6. Circuit arrangement according to one of Claims 1 to 5, characterized in that the feedback resistance (3) of the operational amplifier (2) is variable.

7. Circuit arrangement according to one of Claims 4 to 6, characterized in that the calibration resistance (8) and the feedback resistance (3) are of equal value, constructed in a similar manner and connected in the same manner to the calibration control loop (integrator 23).

8. Circuit arrangement according to one of Claims 1 to 7, characterized in that at least one capacitance (17, 18, 19) is constructed as a series circuit of two part-capacitances (a, b), and that the part-capacitance (a) which is arranged closer to the bridge circuit or connected to it is by-passed by a compensating circuit (c) in such a manner that the direct voltage on both sides of this part-capacitance (a) is approximately of equal magnitude.

9. Circuit arrangement according to one of Claims 4 to 9, characterized in that the calibration control loop is constructed as integrator (23).

10. Circuit arrangement according to one of Claims 1 to 9, characterized in that the series circuit of the first branch resistance (4) and of the second branch resistance (5), on the one hand, and the calibration resistance (8), on the other hand, are located in different branches of the bridge circuit.

11. Circuit arrangement according to Claim 4, characterized in that one of the branch resistances (31, 32) forms the calibration resistance.

12. Circuit arrangement according to one of Claims 4 or 11, characterized in that the calibration point of the bridge circuit is located between one of the branch resistances (5) and the input of the operational amplifier (1), and that the calibration control loop (integrator 23) is controlled by the output signal of the operational amplifier (1).

13. Application of a circuit arrangement according to one of Claims 8 to 12 for the processing of the output signal of a voltage converter (28) constructed as capacitive voltage divider.


**Revendications**

1. Montage de circuit pour convertir une tension d'entrée située dans un domaine de fréquence de travail prédéfini en une tension de sortie proportionnelle, qui présente les caractéristiques suivantes:
   - il contient un circuit amplificateur comportant un amplificateur opérationnel (2) qui présente une sortie connectée à la sortie du montage de circuit et qui est connecté par son entrée inverseuse par l'intermédiaire d'une résistance de contre-réaction (3), une impédance de conversion (4, 5) étant prévue à titre de résistance d'entrée entre la dite entrée et l'entrée du montage de circuit,
   - l'impédance de conversion est formée de deux résistances (4, 5) montées dans deux branches parallèles l'une à l'autre,

- au moins dans l'une des deux branches, une première capacité (17 ou 18) est montée en série avec la résistance de dérivation respective (4, 5), d'une manière telle que les deux résistances de dérivation (4, 5) soient montées en parallèle pour des signaux tombant dans le domaine de fréquence de travail,

- les deux résistances de dérivation (4, 5) sont par ailleurs montées en série dans une branche d'un montages en pont alimenté par une source de tension continue (16),

- des moyens (23, 15, 13 ou 32) sont prévus pour toujours corriger le facteur de conversion du montage de circuit en fonction de l'état d'équilibre du montage en pont de façon qu'il reste constant malgré une variation de valeur de résistance des résistances de dérivation (4, 5), par exemple sous l'effet d'un viellissement ou de variations de température.

2. Montage de circuit suivant la revendication 1, caractérisé en ce que les deux résistances de dérivation (4, 5) sont au moins à peu près identiques.

3. Montage de circuit suivant la revendication 1 ou 2, caractérisé en ce qu'une deuxième capacité (18) est connectée entre son entrée et l'impédance de conversion (4, 5).

4. Montage de circuit suivant l'une quelconque des revendications 1 à 3, caractérisé en ce qu'il contient une résistance d'équilibrage (8) dans le montage en pont, de même qu'un circuit de réglage d'équilibre (intégrateur 23), dont l'entrée est située en un point d'équilibrage (22) du montage en pont et qui équilibre celui-ci par réglage de la résistance d'équilibrage.

5. Montage de circuit suivant l'une quelconque des revendications 1 à 4, caractérisé en ce que, dans les deux branches, une capacité (17, 18) est montée en série avec la résistance de dérivation respective (4, 5) d'une manière telle que les deux résistances de dérivation (4, 5) soient montées en parallèle pour des signaux tombant dans le domaine de fréquence de travail.

6. Montage de circuit suivant l'une quelconque des revendications 1 à 5, caractérisé en ce que la résistance de contre-réaction (3) de l'amplificateur opérationnel (2) est variable.

7. Montage de circuit suivant l'une quelconque des revendications 4 à 6, caractérisé en ce que la résistance d'équlibrage (8) et la résistance de contre-réaction (3) sont d'égale grandeur, de structure semblabe et connectées de la même manière au circuit de réglage d'équlibre (intégrateur 23).

8. Montage de circuit suivant l'une quelconque des revendications 1 à 7, caractérisé en ce qu'au moins une capacité (17, 18, 19) a la forme d'un montage en série de deux capacités partielles (a, b) et que la capacité partielle (a), qui est plus proche du montage en pont ou est connectée à celui-ci, est pontée par un circuit d'équilibrage (c), d'une manière telle que la tension continue ait à peu près la même valeur de part et d'autre de cette capacité partielle (a).

9. Montage de circuit suivant l'une quelconque des revendications 4 à 9, caractérisé en ce que le circuit de réglage d'équilibre a la forme d'un intégrteur (23).

10. Montage de circuit suivant l'une quelconque des revendications 1 à 9, caractérisé en ce que le montage en série de la première résistance de dérivation (4) et de la deuxième résistance de dérivation (5) d'une part, et la résistance d'équilibrage (8) d'autre part, sont situés dans des branches différentes du montage en pont.

11. Montage de circuit suivant la revendication 4, caractérisé en ce que l'une des résistances de dérivation (31, 32) forme la résistance d'équilibrage.

12. Montage de circuit suivant la revendication 4 ou 11, caractérisé en ce que l'endroit d'équilibrage du montage en pont est situé entre l'une des résistances de dérivation (5) et l'entrée de l'amplificateur opérationnel (1), et que le circuit de réglage d'équilibre (intégrateur 23) est commandé par le signal de sortie de l'amplificateur opérationnel (1).

13. Utilisation d'un montage de circuit suivant l'une quelconque des revendications 8 à 12 pour le traitement du signal de sortie d'un transformateur de tension (28) ayant la forme d'un diviseur de tension capacitif.

Fig. 1

Fig. 2

0 135 759